# EUROPÄISCHE PATENTSCHRIFT

(11) **EP 0 607 846 B1**
(45) Veröffentlichungstag und Bekanntmachung des Hinweises auf die Patenterteilung: **27.09.1995**
(21) Anmeldenummer: 94100306.3
(22) Anmeldetag: 11.01.1994
(51) Int. Cl.: H05K 7/20

(54) **Einstückiges Kunststoffteil, insbesondere Spritzgiessteil**
One piece plastic part, especially injection molded part
Article en matière plastique en une pièce, en particulier une pièce fait par moulage par injection

(30) Priorität: 22.01.1993 DE 9300865 U
(43) Veröffentlichungstag der Anmeldung: 27.07.1994
(73) Patentinhaber: SIEMENS AKTIENGESELLSCHAFT, 80333 München (DE)
(72) Erfinder: Schönberger, Eduard, Dipl.-Ing. (FH), D-92245 Kümmersbruck (DE); Kasowski, Hermann, Dipl.-Ing. (FH), D-92280 Kastl (DE); Gruber, Stefan, Dipl.-Ing. (FH), D-92245 Kümmersbruck (DE); Schmidt, Heinz, Dipl.-Ing. (FH), D-92245 Kümmersbruck (DE)

(56) Entgegenhaltungen:
- EP-A- 0 306 412
- EP-A- 0 465 693
- FR-A- 2 560 731

## Beschreibung

Die vorliegende Erfindung betrifft ein Kunststoffteil gemäß dem Oberbegriff des Anspruchs 1. Ein derartiges Kunststoffteil ist beispielsweise aus der EP 0 465 693 A1 bekannt. Auch beim Automatisierungsgerät SIMATIC S5-95 U der Siemens AG wird ein derartiges Kunststoffteil als Gehäuserückwand verwendet.

Aus konstruktiven Gründen kann es nötig sein, die als Kühlfläche wirkende Außenfläche von dem zu kühlenden elektronischen Bauelement entfernt anzuordnen. In diesem Fall stellt sich das Problem, trotz dieser voneinander entfernten Anordnung von Bauelement und Außenfläche eine wirksame Kühlung des Bauelements durch die Außenfläche zu gewährleisten. Das Problem wird durch das Kennzeichen des Anspruchs 1 gelöst.

Wenn das Kunststoffteil den Metallblock allseitig umschließt, ist der Metallblock im Kunststoffteil besonders sicher und unverlierbar gehalten. Das Eingießen des Metallblocks kann dabei in der sogenannten Insert-Technik erfolgen.

Wenn die thermisch leitende Verbindung des Metallblocks mit der Außenfläche im Inneren des Kunststoffteils angeordnet ist, erfolgen durch die thermisch leitende Verbindung von Metallblock und Außenfläche keinerlei Beeinträchtigungen in der Führung der Leiterzüge.

Wenn der Metallblock von dem elektronischen Bauelement elektrisch getrennt ist, kann der Metallblock mit mehreren Bauelementen, die verschiedene Potentiale aufweisen, gekoppelt sein.

Wenn der Metallblock mit dem elektronischen Bauelement elektrisch und thermisch leitend verbunden ist, ist eine besonders gute Wärmeabfuhr gewährleistet.

Weitere Vorteile und Einzelheiten ergeben sich aus der nachfolgenden Beschreibung eines Ausführungsbeispiels und in Verbindung mit den Zeichnungen. Dabei zeigt:

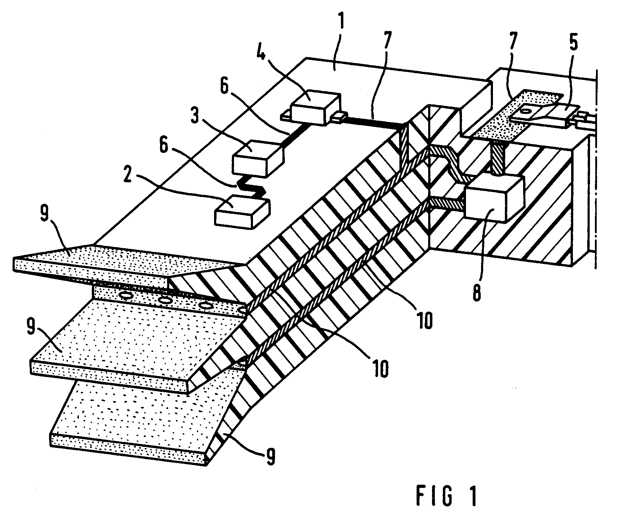

- FIG 1: ein Kunststoffteil in perspektivischer Darstellung im Teilschnitt.

Gemäß FIG 1 ist das als Schaltungsträger ausgebildete Spritzgießteil 1 mit elektronischen Bauelementen 2 bis 5 bestückt, die über Leiterzüge 6, 7 elektrisch leitend miteinander verbunden sind. Die Leiterzüge 6, 7 sind dabei dadurch entstanden, daß das Spritzgießteil 1 nach dem Spritzgießen großflächig metallisiert wurde und die Metallschicht dann zwischen den Leiterzügen 6, 7 entfernt wurde.

Die Bauelemente 4 und 5 sind Leistungselemente, die im Betrieb gekühlt werden müssen. Die Abwärme der Bauelemente 4 und 5 wird daher über die Leiterzüge 7 auf den Metallblock 8 abgeleitet, der im Inneren des Spritzgießteils 1 angeordnet und allseitig vom Spritzgießteil 1 umschlossen ist. Der Metallblock 8 ist mit den Bauelementen 4 und 5 elektrisch und thermisch leitend verbunden. Er dient als Wärmesenke bei kurzzeitigen Belastungsspitzen der Bauelemente 4 und 5.

Der Metallblock ist auch, z. B. über den Leiterzug 7, mit dem Massepotential verbunden. Der Metallblock 8 weist selbst Massepotential auf. Ein versehentliches Berühren der Kühlrippen 9, die auf ihren Außenflächen großflächig metallisiert sind und mit dem Metallblock 8 über im Inneren des Spritzgießteils 1 angeordnete, metallisierte Kanäle 10 verbunden sind, kann daher die berührende Person nicht gefährden. Sowohl die Kühlrippen 9 als auch die Kanäle 10 wurden dabei beim oben erwähnten Metallisieren des Spritzgießteils 1 mit beschichtet.

Alternativ zu der elektrisch und thermisch leitenden Verbindung des Metallblocks 8 mit den Bauelementen 4 und 5 ist es selbstverständlich auch möglich, den Metallblock 8 derart anzuordnen, daß er beispielsweise vom Bauelement 5 durch eine dünne Kunststoffschicht von z. B. 0,3 mm Dicke elektrisch getrennt ist, trotz dieser Kunststoffschicht aber thermisch mit dem Bauelement 5 gekoppelt ist. In diesem Fall hätte ein Berühren der Kühlrippen 9 auch mit Sicherheit keine Schädigung des Bauelements 5 bzw. der auf dem Spritzgießteil 1 angeordneten Schaltung als ganzes zur Folge. Darüber hinaus können bei einer derartigen elektrischen Trennung auch mehrere verschiedene Bauelemente, die verschiedene Potentiale aufweisen, oder ein Bauelemente, deren Potential nicht dem Massepotential entspricht, durch den selben Metallblock bzw. durch elektrisch leitend miteinander verbundene Metallblöcke gekühlt werden.

## Patentansprüche

1. Einstückiges Kunststoffteil, insbesondere Spritzgießteil, mit mindestens einer metallisierten, als Kühlfläche wirkenden Außenfläche und mit Leiterzügen zur elektrisch leitenden Verbindung elektronischer Bauelemente, die auf dem Kunststoffteil angeordnet sind, **dadurch gekennzeichnet**, daß das Kunststoffteil (1) mindestens einen Metallblock (8) umschließt, daß der Metallblock (8) mit mindestens einem (4,5) der elektronischen Bauelemente (2 bis 5) thermisch gekoppelt ist und daß der Metallblock (8) mit der Außenfläche (9) thermisch leitend verbunden ist.

2. Kunststoffteil nach Anspruch 1, **dadurch gekennzeichnet,** daß es den Metallblock (8) allseitig umschließt.

3. Kunststoffteil nach Anspruch 1 oder 2, **dadurch gekennzeichnet**, daß die thermisch leitende Verbindung (10) des Metallblocks (8) mit der Außenfläche (9) im Inneren des Kunststoffteils (1) angeordnet ist.

4. Kunststoffteil nach Anspruch 1, 2 oder 3, **dadurch gekennzeichnet**, daß der Metallblock (8) von dem elektronischen Bauelement (z. B. 5) elektrisch getrennt ist.

5. Kunststoffteil nach Anspruch 1, 2 oder 3, **dadurch gekennzeichnet**, daß der Metallblock (8) mit dem elektronischen Bauelement (4,5) elektrisch und thermisch leitend verbunden ist.

## Claims

1. A single-piece plastics material part, more particularly an injection-moulded part, comprising at least one metallised outer surface acting as a cooling surface and conductors for the electroconductive connection of electronic components which are arranged on the plastics material part, characterised in that the plastics material part (1) encloses at least one metal block (8), the metal block (8) is thermally coupled to at least one (4, 5) of the electronic components (2 to 5) and the metal block (8) is thermally conductively connected to the outer surface (9).

2. A plastics material part according to claim 1, characterised in that it encloses the metal block (8) on all sides.

3. A plastics material part according to claim 1 or 2, characterised in that the thermally conductive connection (10) between the metal block (8) and the outer surface (9) is arranged in the interior of the plastics material part (1).

4. A plastics material part according to claim 1, 2 or 3, characterised in that the metal block (8) is electrically isolated from the electronic component (e.g. 5).

5. A plaatics material part according to claim 1, 2 or 3, characterised in that the metal block (8) is thermally and electroconductively connected to the electronic component (4, 5).

## Revendications

1. Pièce en matière plastique monobloc, notamment pièce moulée par injection, comportant au moins une surface extérieure métallisée agissant en tant que surface de refroidissement, et des voies conductrices pour la liaison électriquement conductrice de composants électroniques qui sont disposés sur la pièce en matière plastique, caractérisée par le fait que la pièce en matière plastique (1) entoure au moins un bloc métallique (8), que le bloc métallique (8) est couplé thermiquement à au moins l'un (4,5) des composants électroniques (2 à 5) et que le bloc métallique (8) est relié d'une manière thermoconductrice à la surface extérieure (9).

2. Pièce en matière plastique suivant la revendication 1, caractérisée par le fait qu'elle entoure le bloc métallique (8) de tous côtés.

3. Pièce en matière plastique suivant la revendication 1 ou 2, caractérisée par le fait que la liaison thermoconductrice (10) du bloc métallique (8) avec la surface extérieure (9) est disposée à l'intérieur de la pièce en matière plastique (1).

4. Pièce en matière plastique suivant la revendication 1, 2 ou 3, caractérisée par le fait que le bloc métallique (8) est séparé électriquement du composant électronique (par exemple 5).

5. Pièce en matière plastique suivant la revendication 1, 2 ou 3, caractérisée par le fait que le bloc métallique (8) est relié d'une manière électriquement conductrice et d'une manière thermoconductrice au composant électronique (4,5).
